(19) Europäisches Patentamt
European Patent Office
Office européen des brevets

(11) **EP 1 913 650 B1**

(12) **FASCICULE DE BREVET EUROPEEN**

(45) Date de publication et mention
de la délivrance du brevet:
**13.06.2012 Bulletin 2012/24**

(21) Numéro de dépôt: **06777868.8**

(22) Date de dépôt: **20.07.2006**

(51) Int Cl.:
*H01L 41/22* (2006.01)    *B06B 1/06* (2006.01)

(86) Numéro de dépôt international:
**PCT/EP2006/064472**

(87) Numéro de publication internationale:
**WO 2007/012604 (01.02.2007 Gazette 2007/05)**

(54) **PROCEDE DE FABRICATION D'UN TRANSDUCTEUR ACOUSTIQUE**

VERFAHREN ZUM HERSTELLEN EINES AKUSTISCHEN WANDLERS

METHOD FOR MAKING AN ACOUSTIC TRANSDUCER

(84) Etats contractants désignés:
**AT BE BG CH CY CZ DE DK EE ES FI FR GB GR
HU IE IS IT LI LT LU LV MC NL PL PT RO SE SI
SK TR**

(30) Priorité: **29.07.2005 FR 0508132**

(43) Date de publication de la demande:
**23.04.2008 Bulletin 2008/17**

(73) Titulaire: **THALES**
**92200 Neuilly sur Seine (FR)**

(72) Inventeurs:
- **ROUX, Gérard**
  **F-06650 Opio (FR)**
- **PONTHUS, Sylvie**
  **F-06560 Valbonne (FR)**

(74) Mandataire: **Lucas, Laurent Jacques**
**Marks & Clerk France**
**Conseils en Propriété Industrielle**
**Immeuble Visium**
**22, Avenue Aristide Briand**
**94117 Arcueil Cedex (FR)**

(56) Documents cités:
**EP-A- 0 694 339     US-A- 5 548 564
US-A- 5 844 349**

- **COCHRAN A ET AL: "Multilayer piezocomposite transducers for applications of low frequency ultrasound" PROCEEDINGS 1997 IEEE ULTRASONICS SYMPOSIUM, TORONTO, CANANDA, 5-8 OCTOBER 1997, vol. 2, 1997, pages 1013-1016, XP010271441 ISBN: 0-7803-4153-8**
- **OAKLEY C G ET AL: "Stacked composite piezoelectric materials for 1.5-D arrays" PROCEEDINGS 1997 IEEE ULTRASONICS SYMPOSIUM, TORONTO, CANANDA, 5-8 OCTOBER 1997, vol. 2, 1997, pages 923-926, XP010271496 ISBN: 0-7803-4153-8**

EP 1 913 650 B1

## Description

## DOMAINE DE L'INVENTION

La présente invention concerne la fabrication de transducteurs acoustiques, à partir de matériaux composites. Elle intéresse en particulier le domaine des détecteurs sonars destinés à la détection d'objets situés à une distance relativement faible du détecteur.

## CONTEXTE DE L'INVENTION - ART ANTERIEUR

Pour obtenir un transducteur acoustique fonctionnant à haute fréquence, il est connu d'utiliser des matériaux composites à la place de céramiques pleines. L'emploi de matériaux composites, tels que les composites 1-3 par exemple, pour réaliser un transducteur permet en effet de simplifier la réalisation du capteur acoustique correspondant. Un tel transducteur peut en en particulier être totalement inclus dans un substrat de remplissage de type polyuréthane par exemple, sans qu'il soit besoin de ménager autour des faces non actives un espace vide ne transmettant pas la pression.

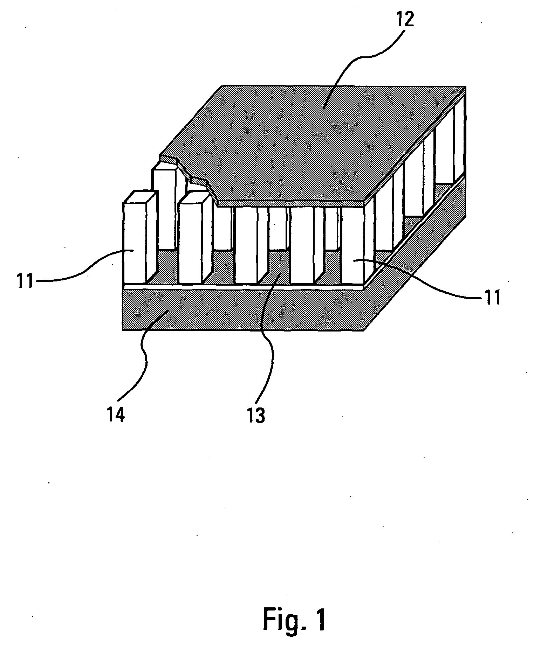

La figure 1 annexée présente de manière schématique la structure d'un tel composite. Ce composite est constitué de plots de céramique 11 de forme parallélépipédique, à section carrée de l'ordre du mm² par exemple, et de hauteur h. Ces plots sont généralement répartis sur un plan selon des lignes et des colonnes orthogonales. La tenue mécanique de l'ensemble des plots est assurée en remplissant les espaces libres entre les plots avec une matrice en matériau diélectrique approprié, non représentée sur la figure. Pour réaliser un transducteur, il suffit ensuite de déposer des couches de matériau conducteur 12, 13 sur les surfaces actives du morceau de matériau utilisé. Le transducteur ainsi réalisé peut être monté sur une couche 14 de matériau absorbant ou " backing ".
De manière connue une plaque de matériau composite est obtenue à partir d'une plaque de céramique pleine par l'usinage de cannelures parallèles de largeurs identiques et disposées selon deux directions perpendiculaires. Ce double usinage permet de former une structure simple, constituée de plots alignés 11.

Un bloc de matériau composite tel que celui décrit précédemment est relativement facile à réaliser pour des fréquences de travail de l'ordre du mégahertz. En effet, la hauteur h des plots de céramique à réaliser est alors faible, de l'ordre de quelques dixièmes de millimètres à un millimètre, hauteur qu'il est relativement facile d'obtenir par usinage d'une plaque de céramique. En revanche, lorsqu'il s'agit de réaliser un bloc de matériau adapté à une fréquence acoustique plus basse, de l'ordre d'une centaine de kilohertz par exemple, à partir d'une même plaque de céramique, on est affronté à deux problèmes techniques distincts.
Le premier problème rencontré réside dans la difficulté de réaliser par usinage des plots de plus grande hauteur, nécessaires pour réaliser un composite dont la fréquence de travail est de l'ordre de la centaine de kilohertz. Pour une telle fréquence de travail la hauteur des plots doit être de plusieurs millimètres alors qu'il est difficile d'obtenir par usinage des plots d'une hauteur supérieure à 5mm. Les techniques d'usinage classiques occasionnent fréquemment dans ce cas une casse des céramiques usinées et on observe un taux de rebuts très élevé. Le deuxième problème important soulevé par la réalisation en matériau composite de transducteurs basse fréquence, est d'ordre électrique. En effet, comme le montre la figure 1, un tel transducteur est connecté électriquement au moyen de deux plaques métalliques 12 et 13 disposées sur la face supérieure et sur la face inférieure du transducteur. Chaque plot peut alors être considéré comme un condensateur dont la capacité a pour expression générale connue: $C = \varepsilon \dfrac{s}{h}$ où $\varepsilon$ représente la constante diélectrique de la céramique utilisée, h la hauteur du plot et s sa section. Par sa capacité propre chaque plot contribue à la capacité du transducteur. Par conséquent, la capacité d'un transducteur réalisé en matériau composite dépend de l'épaisseur du matériau, de sorte que un transducteur de basse fréquence présentera une capacité plus faible qu'un transducteur de plus haute fréquence. Pour une fréquence de travail de l'ordre de la centaine de kilohertz la valeur de la capacité présentée par le transducteur est à ce point faible qu'elle entraîne une mauvaise adaptation d'impédance responsable de l'apparition d'un bruit électrique qui entrave le fonctionnement global du capteur.
L'inconvénient majeur de l'utilisation de matériaux composites pour réaliser des transducteurs fonctionnant à une fréquence située autour de la centaine de kilohertz avec une bonne sensibilité, réside donc dans la difficulté de réalisation du transducteur et dans la limitation de ses caractéristiques électriques qui induit une limitation de ses performances.

Une solution connue pour réaliser un transducteur acoustique basse fréquence à partir d'un matériau de type composite 1-3 de surface donnée ayant à la fois la hauteur h voulue et une valeur de capacité électrique permettant de maintenir le bruit électrique à un niveau acceptable, consiste à effectuer la superposition de deux ou plusieurs transducteurs de même type fonctionnant à une fréquence donnée ainsi que leur mise en parallèle, du point de vue électrique.

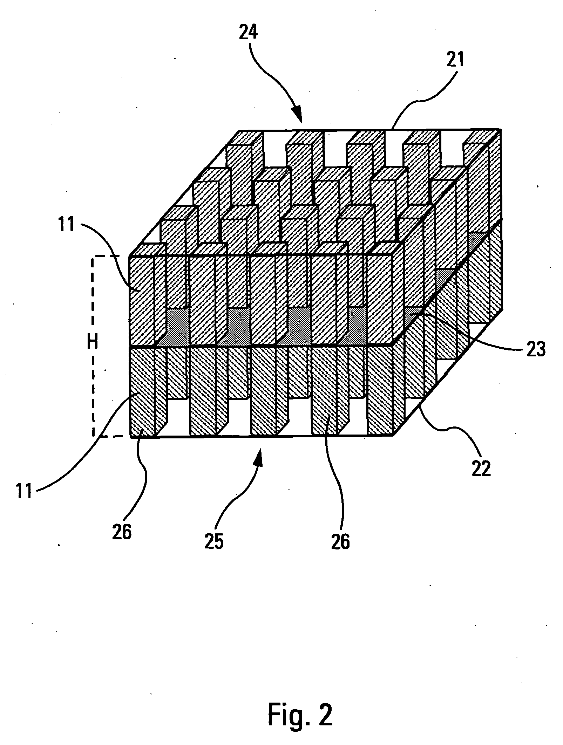

La figure 2 annexée illustre le dispositif théoriquement obtenu dans un cas idéal de réalisation. Elle présente deux transducteurs 21 et 22 identiques représentés schématiquement par leurs plots de céramique. Les deux transducteurs sont superposés de façon à ce que les axes de polarisation des éléments de céramique soient orientés en sens opposé. Au plan de contact entre les deux transducteurs est interposée une électrode métallique plane 23. Deux électrodes planes sont également placées sur les faces 24 et 25 opposées au plan de contact et reliées électriquement l'une à l'autre. De la sorte, du point de vue électrique, les deux transducteurs 21 et 22 sont mis en parallèle et leurs capacités électriques s'ajoutent. En outre, la superposition permet de réaliser de manière artificielle un transducteur comportant des plots de céramique 26 constitués par la superposition des plots 11 appartenant respectivement à chacun des transducteurs 21 et 22. La hauteur H de chaque plot 26 ainsi constitué est avantageusement égale à deux fois la hauteur h de chacun des transducteurs assemblés 21 et 22. On obtient ainsi un transducteur dont la fréquence de travail est deux fois inférieure à celle des deux transducteurs qui le constituent.

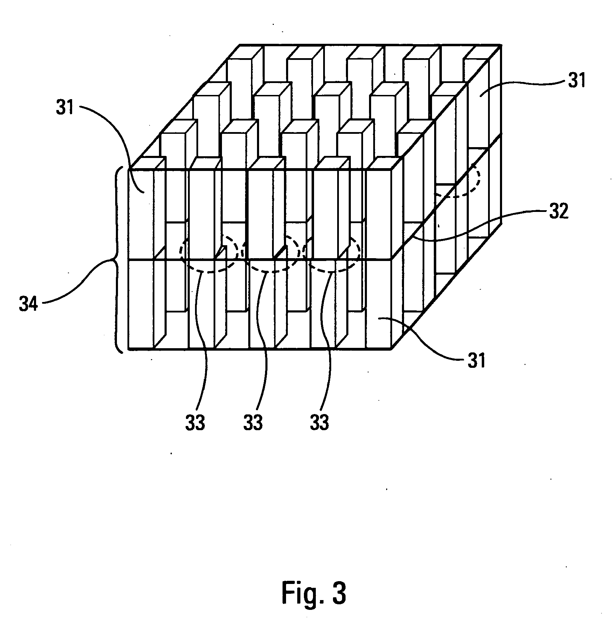

L'efficacité de cette solution par ailleurs connue est conditionnée par la qualité avec laquelle les transducteurs sont réalisés et superposés. En effet, pour que le transducteur résultant fonctionne de manière satisfaisante et présente un seul pic de résonance avec une amplitude exploitable il est nécessaire que la superposition soit réalisée de manière suffisamment exacte pour que pour une ligne ou une colonne donnée les plots superposés soient rigoureusement alignés et leurs faces orientées de manière identique. Or les méthodes de réalisation de composites connues et utilisées à ce jour ne permettent pas de réaliser des composites comportant des arrangements de plots suffisamment réguliers pour qu'un positionnement exact de tous les plots se faisant face à la suite de la superposition de plusieurs transducteurs soit possible. Dans la pratique on obtient généralement comme l'illustre la figure 3 des transducteurs comportant arrangement de plots 31 selon des rangées et des colonnes plus ou moins rectilignes et dont la superposition présente des imperfections d'alignement 33 dans le plan de superposition 32. Ces imperfections ont principalement pour conséquence de conduire à un défaut d'alignement de certains des plots reconstitués 34 formés par la superposition des deux transducteurs. Ce défaut d'alignement se traduit par l'apparition de pertes donc une forte diminution de l'amplitude du pic de résonance à la fréquence de travail souhaitée.

Il est connu du document de brevet US 5 844 349 (OAKLEY et AL), délivré le premier décembre 1998, de réaliser un bloc de matériau composite piézoélectrique constitué de rangées de plots de céramique superposés et immergés dans un matériau diélectrique, à partir de couches superposées de structure planes elles-mêmes formées de barreaux, ou bandes, de céramique piézoélectrique séparés par un matériau diélectrique. Selon ce document les structures planes sont liées les unes aux autres et des fentes sont réalisées perpendiculairement à l'axe des barreaux de céramique, de façon à former un bloc comportant des plots superposés séparés, agencés en colonnes séparées par un substrat diélectrique. Cependant, ce document ne propose aucun procédé particulier permettant de garantir, par fabrication, l'alignement strict des plots formés, de façon, en particulier, à ce que chaque colonne de plots puisse présenter des propriétés acoustiques et électriques semblables à celle d'un plot de céramique unique ayant la longueur de la colonne de plots considérée.

## PRESENTATION DE L'INVENTION

Un but de l'invention est de proposer une méthode pour réaliser des transducteurs basse fréquence, adapté à des fréquences typiquement de l'ordre de 100 kHz, facile à réaliser de manière industrielle et ne présentant pas les défauts des transducteurs réalisés par simple superposition de transducteurs existants. A cet effet l'invention a pour objet un procédé de réalisation d'un bloc de matériau composite piézoélectrique basse fréquence constitué de plots de céramique superposés et dont les interstices sont remplis par un matériau diélectrique Ce procédé comporte les étapes suivantes:

- une étape 1 d'usinage d'un bloc de céramique pour former un ensemble des barreaux parallèles de section rectangulaire maintenus en place par une semelle de céramique,
- une étape 2 de séparation du bloc de céramique en deux demi-blocs identiques par découpe du bloc initial suivant un plan perpendiculaire à l'axe des barreaux,
- une étape 3 de réalisation d'un bloc d'épaisseur double par superposition et assemblage des deux demi-blocs, la superposition étant réalisée de façon à mettre en vis à vis les barreaux de chacun des demi-blocs, une couche d'élément conducteur étant insérée dans le plan de superposition des deux demi-blocs, l'ensemble étant maintenu entre deux semelles de céramique,
- une étape 4 de formation des plots de céramique à partir des barreaux, par réalisation dans le bloc de céramique de découpes perpendiculaires aux barreaux formés à l'étape précédente,
- une étape 5 de remplissage des parties évidées du bloc de céramique avec un matériau diélectrique,
- une étape 6 d'érosion des semelles,
- une étape 7 de dépôt d'une couche conductrice sur les faces externes du bloc de matériau composite ainsi réalisé.

Ce procédé permet avantageusement de réaliser un bloc de matériau composite très régulier car réalisé à partir deux blocs superposables comportant des barreaux de profils sensiblement identiques car réalisés en une même opération à partir d'un même bloc initial de céramique.

Une fois superposés et assemblés, ces deux blocs n'en ferment plus qu'un seul, d'épaisseur double déjà partiellement évidé, qu'il est facile d'usiner pour former des plots bien alignés et correctement superposés. Avantageusement, les barreaux étant usinés de façon à rester solidaires d'une couche, ou semelle, de céramique l'écartement entre les barreaux est maintenu constant ce qui permet d'assurer une superposition précise de tous les barreaux, ainsi qu'un maintien en position pendant l'opération de réalisation des plots. Cette structure en sandwich présente également l'avantage de renforcer la solidité du matériau pendant l'usinage des plots et ainsi de limiter les risque de casse. Les couches de céramique ne sont enlevées par érosion ou polissage qu'à l'issue de l'étape de remplissage.

## DESCRIPTION DES FIGURES

Les caractéristiques et avantages du procédé selon l'invention apparaîtront clairement dans la description qui suit, description illustrée par les figures annexées qui représentent:

- la figure 1, la représentation schématique d'un transducteur haute fréquence, réalisé à l'aide d'un bloc de matériau composite,
- la figure 2, la représentation d'un transducteur idéal réalisé par superposition de deux blocs de matériaux composites,
- la figure 3, une illustration des problèmes posés par les méthodes de réalisation connues,
- la figure 4, l'illustration des étapes 1 à 4 du procédé selon l'invention,
- la figure 5, l'illustration des étapes 5 à 7 du procédé selon l'invention.

## DESCRIPTION DETAILLEE

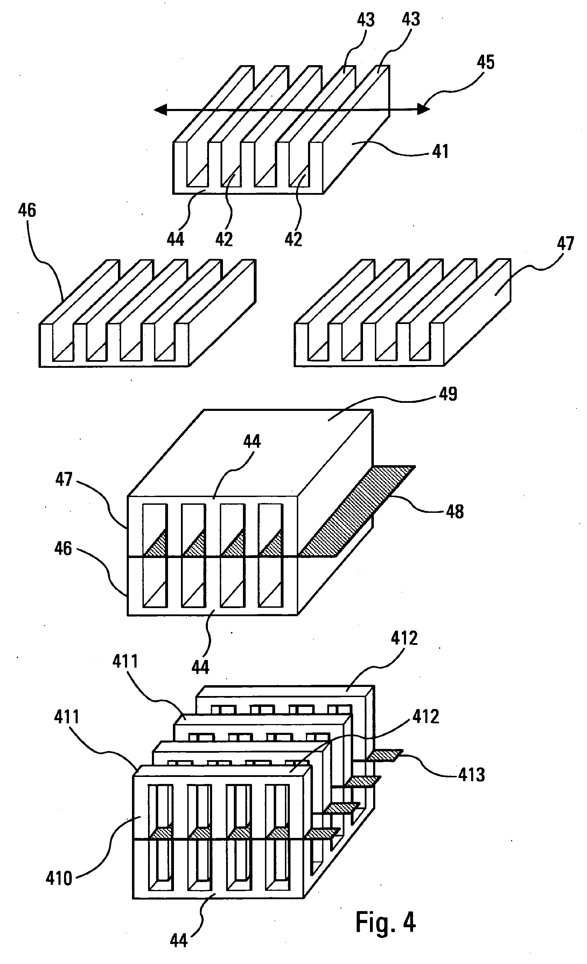

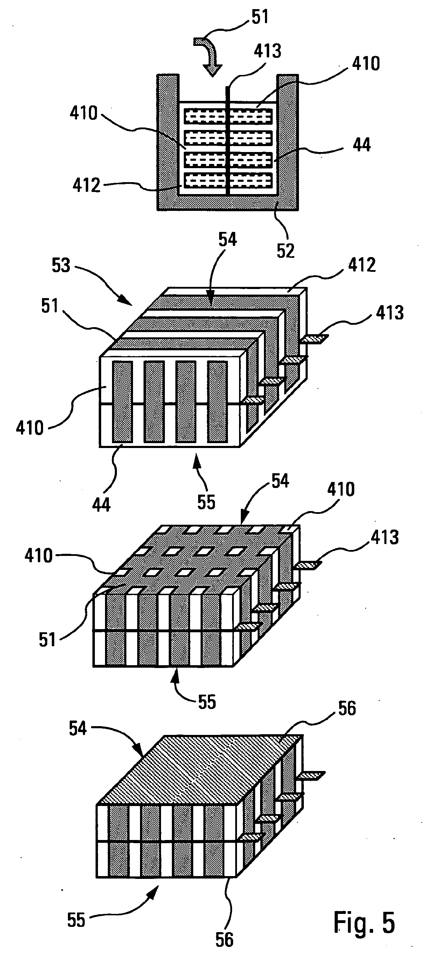

Le procédé selon l'invention peut être aisément décrit à l'aide des illustrations des figures 4 et 5.
On considère tout d'abord la figure 4.
Selon l'invention pour réaliser un transducteur basse fréquence, on procède comme suit. Au cours d'une première étape, on réalise dans un morceau de céramique piézoélectrique d'épaisseur h un certain nombre de rainures parallèles 42 de façon à constituer un ensemble de barreaux parallèles 43, maintenus solidaires entre eux par une couche de céramique 44, ou semelle, d'épaisseur e de préférence faible. On réalise ainsi un ensemble de barreaux parallèles dont l'écartement est avantageusement bien maîtrisé. Les rainures 41 peuvent par exemple être réalisées par sciage selon une technique bien connue et non décrite ici.

Au cours d'une deuxième étape, le morceau de céramique ainsi usiné est découpé en deux blocs identiques 46 et 47, selon un plan de coupe perpendiculaire aux axes des barreaux et matérialisé par l'axe 45 sur la figure. On obtient ainsi deux blocs jumeaux dont les barreaux sont superposables avec précision.

Ensuite, au cours d'une troisième étape, les deux blocs ainsi obtenus sont superposés et assemblés par collage par exemple. Lors de l'assemblage, une feuille de matériau conducteur dont la surface est supérieure à celle des blocs 46 et 47 est interposée entre les deux blocs, dans le plan de superposition. La feuille de matériau conducteur 48 est positionnée de façon à ce qu'un de ses côtés soit extérieur au bloc de matériau 49 ainsi réalisé. Ce bloc se présente sous la forme de barreaux d'épaisseur 2h emprisonnés entre deux couches de céramique 44 dont ils sont solidaires. Ces deux couches de céramique assurent avantageusement le maintien en place de barreaux.

Lors de la quatrième étape, on effectue dans le bloc de matériau obtenu à l'étape précédente une série de découpes parallèles entre elles, selon des axes perpendiculaires aux axes des barreaux 43 qui constituent le bloc de matériau. Selon l'invention, les rainures ainsi formées ont de préférence une largeur égale à celle des rainures 42 réalisées lors de la première étape.

On obtient ainsi un ensemble de plots de céramique 410 disposés selon des rangées identiques 411 rigoureusement parallèles.

Avantageusement, lors de cette étape de découpe, les barreaux sont maintenus en position par les couches externes 44 qui les bordent. De la sorte, l'opération de sciage est réalisée en minimisant les risques de casse. Ainsi dans une même rangée 411 les plots 410 sont maintenus en position à une extrémité par une couche de céramique 44 et à l'autre extrémité par des bandes de céramique 412 issues de l'usinage de la couche opposée. Comme l'illustre la figure 4, à l'issue de cette quatrième étape la feuille de matériau conducteur est découpée en bandes conductrices 413 reliant entre eux tous les plots d'une même rangée 411.

On considère à présent la figure 5, qui illustre la suite des étapes du procédé selon l'invention.

Comme l'illustre cette figure l'étape quatre est suivie d'une cinquième étape qui consiste à combler les espaces vides séparant les plots de céramiques 410 les uns des autres en coulant entre ces plots un matériau diélectrique 51, un polymère par exemple.

La coulée est par exemple réalisée par la face qui laisse dépasser les bandes conductrices 413, les autres faces étant par ailleurs obturées au moyen d'un outillage 52 formant une boite. Sitôt que le matériau coulé est solidifié, l'outillage 52 est démonté et laisse apparaître le bloc de matériau composite 53 ainsi obtenu.

Lors de l'étape 6, ce bloc de matériau subit ensuite une opération d'érosion des faces 54 et 55 parallèles au plan des bandes conductrices 413. Du fait de la faible épaisseur des bandes de céramique 412 et de la couche de céramique 44, cette opération peut avantageusement être réalisée par polissage des surfaces considérées. On obtient ainsi un bloc de matériau composite qui se présente comme un ensemble de plots de céramique 410 emprisonnés dans une matrice de matériau polymère 51.

Le bloc de matériau composite complet est ensuite achevé au cours d'une étape 7 finale. Durant cette étape chacune des faces polies 54 et 55 est recouverte d'une couche 56 de matériau conducteur, opération qui peut consister en une métallisation des faces 54 et 55. Cette couche peut être continue, comme représenté sur la figure, mais il est également possible de réaliser, selon l'usage envisagé, des métallisations plus complexes de façon à former par exemple des bandes parallèles identiques aux bandes 413 enfouies au sein du matériau.

Un bloc de matériau composite ainsi réalisé par le procédé selon l'invention présente avantageusement en final une structure sensiblement identique à la structure présentée à la figure 2, structure qui, comme cela a été dit précédemment, est extrêmement difficile à obtenir par un quelconque procédé connu.

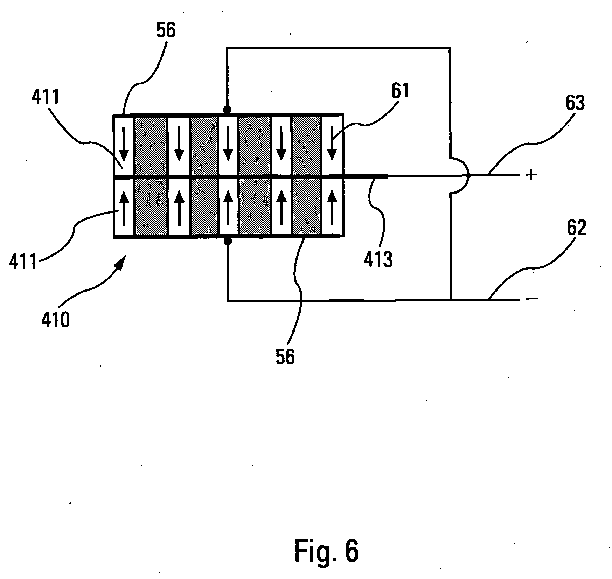

On considère à présent la figure 6 qui permet de bien mettre en évidence les avantages de la réalisation d'un transducteur, à partir d'un morceau de matériau composite fabriqué par le procédé selon l'invention. Comme l'illustre la figure 6, chaque colonne de plots de céramique piézoélectrique peut être électriquement câblée de façon à effectuer la mise en parallèle des plots. Dans cette forme d'assemblage les éléments conducteurs 56 des faces externes sont reliés électriquement pour former un pôle négatif 62 tandis que la bande conductrice interne 413 constitue un pôle positif commun 63. Comme l'indique les flèches 61 sur la figure, lors de la fabrication du morceau de matériau composite, la superposition des deux éléments de céramique 46 et 47 est réalisée de façon à ce que les sens de polarisation des deux éléments permette cette mise en parallèle. L'avantage présenté par un tel montage est important. Il permet en effet d'abord de réaliser un transducteur constitué d'élément capable de résonner à une fréquence plus basse. La mise en parallèle des plots dans l'arrangement illustré par la figure 6 met en opposition de phase les blocs superposés ce qui a pour conséquence d'atténuer fortement la résonance de chaque plot à sa fréquence propre et de renforcer la résonance de l'ensemble à la fréquence moitié qui représente la fréquence de résonance recherchée. Ce montage en parallèle permet également, comme cela a été dit précédemment, de doubler la capacité électrique de l'ensemble par rapport à un transducteur monolithique de même épaisseur.

Le schéma de câblage présenté à la figure 6 illustre la façon dont chaque rangée de plots d'un morceau de matériau composite réalisé par le procédé selon l'invention peut être utilisée pour constituer un transducteur. Chacune des rangées peut ensuite être connectée aux autres pour former le transducteur complet. La connexion des différentes rangées entre elles dépend du mode de fonctionnement du transducteur complet et en particulier de la forme du diagramme de directivité que l'on souhaite réaliser. Une façon simple d'effectuer cette connexion consiste par exemple à associer en parallèle toutes les rangées. Cette façon d'opérer n'est bien entendu pas limitative.

Le procédé selon l'invention est décrit dans les paragraphes précédents dans le cas particulier de réalisation d'un transducteur ayant des plots de tailles identiques. Cet exemple n'est cependant pas limitatif et l'on peut bien évidemment généraliser le procédé sans sortir du contexte de l'invention revendiquée. Il est par exemple possible de réaliser une structure telle que celle illustrée par la figure 3, comportant des plots 34 constitué de deux plots 33 de deux tailles différentes. Il suffit pour cela d'introduire dans le procédé une étape intermédiaire 2 bis, qui prend place entre l'étape 2 et l'étape 3, et durant laquelle ont procédé à une rectification de l'épaisseur d'un des deux demi-blocs de façon à lui donner une épaisseur différente de l'autre demi-bloc. Cette opération peut être réalisée par tout moyen approprié. De la sorte l'assemblage réalisé au cours de l'étape 3 devient dissymétrique. Dans cette variante de réalisation, on obtient une structure comportant des plots dont la capacité correspond à la sommes des capacités des deux plots constituant chaque demi bloc, tandis que la fréquence de résonance obtenue est alors égale à la somme des deux fréquences divisée par 4.

## Revendications

1. Procédé de réalisation d'un bloc de matériau composite piézoélectrique basse fréquence constitué de rangées de plots de céramique superposés et immergés dans un matériau diélectrique, **caractérisé en ce qu'**il comporte les étapes suivantes:

   - une étape 1 d'usinage d'un bloc de céramique (41) pour former un ensemble des barreaux parallèles (43) de section rectangulaire maintenus en place par une semelle de céramique (44),
   - une étape 2 de séparation du bloc de céramique en deux demi-blocs identiques (46, 47) par découpe du bloc initial suivant un plan perpendiculaire à l'axe des barreaux,
   - une étape 3 de réalisation d'un bloc d'épaisseur double par superposition et assemblage des deux demi-blocs (46, 47), la superposition étant réalisée de façon à mettre en vis à vis les barreaux (43) de chacun des demi-blocs, une couche d'élément conducteur (48) étant insérée dans le plan de superposition des deux demi-blocs,
   - une étape 4 de formation de rangées (412) de plots de céramique à partir des barreaux (43), par réalisation dans le bloc de céramique de découpes perpendiculaires aux barreaux formés à l'étape précédente, la couche conductrice située dans le plan de superposition formant des bandes conductrices (413) parallèles reliant entre eux tous les plots d'une même rangée,
   - une étape 5 de remplissage des parties évidées du bloc de céramique avec un matériau diélectrique (51),
   - une étape 6 d'érosion des faces externes du bloc de matériau composite obtenu à l'étape précédente, destinée à enlever les semelles de céramique (44) initialement formées,
   - une étape 7 de dépôt d'une couche (56) de matériau conducteur sur les faces externes (54, 55) du bloc de matériau composite ainsi réalisé.

2. Procédé selon la revendication 1, dans lequel l'opération d'érosion de l'étape 6 est réalisée par polissage.

3. Procédé selon l'une des revendications 1 ou 2, dans lequel lors de l'étape 7 on dépose sur les faces externes du bloc (54, 55) une couche continue de matériau conducteur.

4. Procédé selon l'une des revendications 1 ou 2, dans lequel lors de l'étape 7 on dépose sur les faces externes du bloc (54, 55) une couche discontinue matériau conducteur formant des bandes conductrices parallèles aux bandes conductrices situées dans le plan de superposition.

5. Procédé selon l'une quelconque des revendications précédentes, comportant une étape supplémentaire 2 bis au cours de laquelle un des deux demi-blocs (46, 47) subit une opération de rectification d'épaisseur de sorte que les deux demi-blocs ainsi obtenus sont d'épaisseurs différentes, l'étape 2 bis étant intercalée entre les étapes 2 et 3.

6. Procédé pour réaliser un transducteur piézoélectrique (410), **caractérisé en ce qu'**il consiste à réaliser un bloc de matériau composite par le procédé selon l'une quelconque des revendications précédentes, à réaliser une connexion électrique parallèle entre les bandes conductrices (413) des rangées de plots de céramique (412) du bloc de matériau composite et à relier électriquement les faces externes métallisées (54, 55) de ce bloc.

**Claims**

1. A method for producing a low-frequency piezoelectric composite material block constituted of rows of superposed ceramic contacts and embedded in a dielectric material, **characterised in that** it comprises the following steps:

    - a step 1 of machining a ceramic block (41) so as to form a set of parallel bars (43) of rectangular section, which are held in place by a ceramic base (44),
    - a step 2 of separating said ceramic block into two identical half-blocks (46, 47) by cutting the initial block along a plane that is perpendicular to the axis of the bars,
    - a step 3 of producing a block of double thickness by superposing and assembling the two half-blocks (46, 47), said superposition being undertaken so as to place the bars (43) of each of the half-blocks opposite one another, with a conducting element layer (48) being inserted in the superposition plane of the two half-blocks,
    - a step 4 of forming rows (412) of ceramic contacts from the bars (43) by making cuts in the ceramic block, which are perpendicular to the bars formed during the preceding step, the conducting layer located in the superposition plane forming parallel conducting strips (413) linking together all of the contacts of the same row,
    - a step 5 of filling the hollow parts of the ceramic block with a dielectric material (51),
    - a step 6 of eroding the external faces of the block of composite material obtained during the preceding step so as to remove the initially formed ceramic bases (44),
    - a step 7 of depositing a layer (56) of conducting material on the external faces (54, 55) of the composite material thus produced.

2. The method according to claim 1, wherein the erosion operation of step 6 is performed by polishing.

3. The method according to claim 1 or 2, wherein during step 7 a continuous layer of conducting material is deposited on the external faces of the block (54, 55).

4. The method according to claim 1 or 2, wherein during step 7 a discontinuous layer of conducting material forming conducting strips parallel to the conducting strips located in the superposition plane is deposited on the external faces of the block (54, 55).

5. The method according to any one of the preceding claims, comprising a further step 2a during which one of the two half-blocks (46, 47) undergoes an operation for rectifying the thickness so that the two half-blocks that are thus obtained have different thicknesses, with step 2a being placed between the steps 2 and 3.

6. A method for manufacturing a piezoelectric transducer (410), **characterised in that** it consists in producing a block of composite material using the method according to any one of the preceding claims, producing an electrical connection that is parallel between the conducting strips (413) of the rows of ceramic contacts (412) of the block of composite material and electrically connecting the external metallised faces (54, 55) of this block.

**Patentansprüche**

1. Verfahren zur Herstellung eines piezoelektrischen Niederfrequenz-Verbundmaterialblocks, der aus Reihen von keramischen Kontaktstücken besteht, die übereinander gelegt und in einem dielektrisches Material versenkt sind, **dadurch gekennzeichnet,**

**dass** es die folgenden Schritte beinhaltet:

- einen Schritt 1 des maschinellen Bearbeitens eines Keramikblocks (41), um einen Satz von parallelen Stäben (43) mit rechteckigem Querschnitt zu bilden, die von einer Keramikplatte (44) gehalten werden,
- einen Schritt 2 des Unterteilens des Keramikblocks in zwei identische Blockhälften (46, 47) durch Schneiden des Ausgangsblocks entlang einer Ebene lotrecht zur Achse der Stäbe,
- einen Schritt 3 des Erzeugens eines Blocks doppelter Dicke durch Übereinanderlegen und Zusammenfügen der beiden Blockhälften (46, 47), wobei das Übereinanderlegen so erfolgt, dass die Stäbe (43) jeder der Blockhälften einander gegenüber liegen, wobei eine Schicht (48) eines leitenden Elements in die Übereinanderlageebene der beiden Blockhälften eingefügt wird,
- einen Schritt 4 des Bildens von Reihen (412) von Keramikkontaktstücken aus den Stäben (43) durch Ausführen von Schnitten in dem Keramikblock parallel zu den im vorherigen Schritt gebildeten Stäben, wobei sich die leitende Schicht in der Übereinanderlageebene befindet und parallele Leitungsbänder (413) bildet, die alle Kontaktstücke jeweils derselben Reihe miteinander verbinden,
- einen Schritt 5 des Füllens der hohlen Teile des Keramikblocks mit einem dielektrischen Material (51),
- einen Schritt 6 des Abtragens der Außenflächen des im vorherigen Schritt erhaltenen Verbundmaterialblocks, um die anfänglich gebildeten Keramikplatten (44) zu entfernen,
- einen Schritt 7 des Absetzens einer Schicht (56) aus leitendem Material auf die Außenflächen (54, 55) des so erzeugten Verbundmaterialblocks.

2. Verfahren nach Anspruch 1, wobei das Abtragen in Schritt 6 durch Polieren erfolgt.

3. Verfahren nach Anspruch 1 oder 2, wobei in Schritt 7 eine kontinuierliche Schicht aus leitendem Material auf die Außenflächen des Blocks (54, 55) abgesetzt wird.

4. Verfahren nach Anspruch 1 oder 2, wobei in Schritt 7 eine diskontinuierliche Schicht leitendes Material, das Leitungsbänder parallel zu den in der Aufeinanderlageebene befindlichen Leitungsbänder bildet, auf die Außenflächen des Blocks (54, 55) abgesetzt wird.

5. Verfahren nach einem der vorherigen Ansprüche, das einen weiteren Schritt 2a beinhaltet, bei dem eine der beiden Blockhälften (46, 47) einen Vorgang des Bearbeitens der Dicke erfährt, so dass die beiden erhaltenen Blockhälften unterschiedliche Dicken haben, wobei Schritt 2a zwischen die Schritte 2 und 3 gesetzt wird.

6. Verfahren zum Herstellen eines piezoelektrischen Wandlers (410), **dadurch gekennzeichnet, dass** es darin besteht, einen Verbundmaterialblock mit dem Verfahren nach einem der vorherigen Ansprüche zu erzeugen, eine elektrische Verbindung parallel zwischen den Leitungsbändern (413) der Reihen von Keramikkontaktstücken (412) des Verbundmaterialblocks zu erzeugen und die metallisierten Außenflächen (54, 55) dieses Blocks elektrisch zu verbinden.

**Fig. 1**

Fig. 2

**Fig. 3**

Fig. 4

Fig. 5

Fig. 6

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 5844349 A, OAKLEY